## Europäisches Patentamt
## European Patent Office
## Office européen des brevets

(19)

(11) Veröffentlichungsnummer: **0 174 049**
**A2**

(12) # EUROPÄISCHE PATENTANMELDUNG

(21) Anmeldenummer: **85201373.9**

(22) Anmeldetag: **30.08.85**

(51) Int. Cl.⁴: **H 03 L 7/08**
**H 03 L 7/18**

(30) Priorität: **03.09.84 DE 3432313**

(43) Veröffentlichungstag der Anmeldung:
**12.03.86 Patentblatt 86/11**

(84) Benannte Vertragsstaaten:
**BE DE FR GB IT**

(71) Anmelder: **Philips Patentverwaltung GmbH**
**Billstrasse 80**
**D-2000 Hamburg 28(DE)**

(84) Benannte Vertragsstaaten:
**DE**

(71) Anmelder: **N.V. Philips' Gloeilampenfabrieken**
**Groenewoudseweg 1**
**NL-5621 BA Eindhoven(NL)**

(84) Benannte Vertragsstaaten:
**BE FR GB IT**

(72) Erfinder: **Möring, Wilhelm**
**Clematisweg 12**
**D-2000 Hamburg 54(DE)**

(72) Erfinder: **Demmer, Walter Heinrich**
**Sorthmannweg 15**
**D-2000 Hamburg 54(DE)**

(72) Erfinder: **Oldach, Detlef**
**Dahlgrünring 6**
**D-2102 Hamburg 93(DE)**

(74) Vertreter: **Hartmann, Heinrich, Dipl.-Ing. et al,**
**Philips Patentverwaltung GmbH Billstrasse 80 Postfach**
**10 51 49**
**D-2000 Hamburg 28(DE)**

(54) **Schaltungsanordnung zum Synchronisieren eines Signals.**

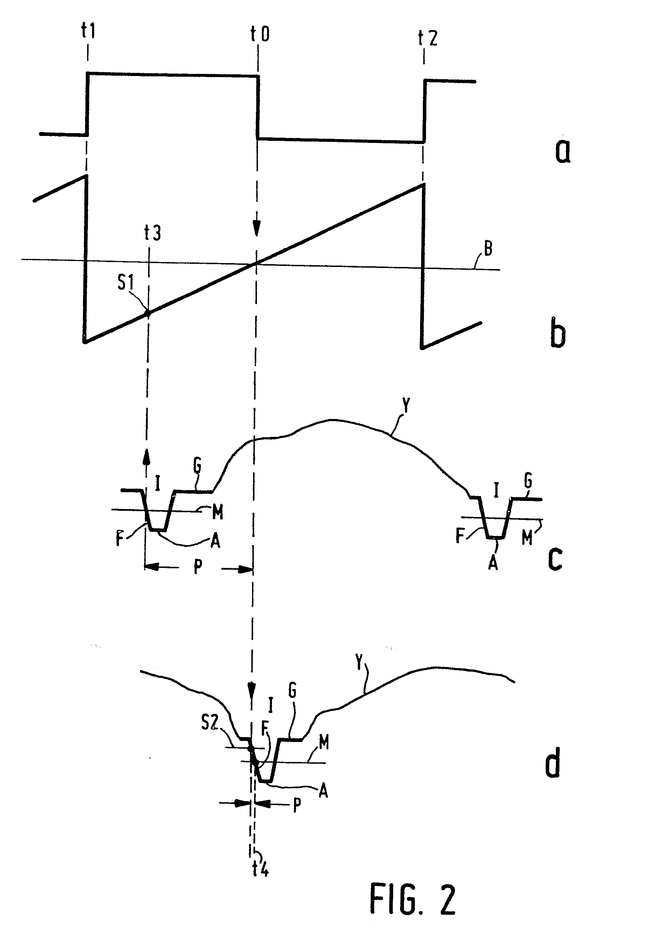

(57) In einer Schaltungsanordnung zum Synchronisieren der Phase eines frequenzgeteilten Signals mit einer Flanke (F) endlicher Steigung eines im wesentlichen periodischen Synchronisiersignals (Fig. 2c) mit einem ein Taktsignal abgebenden Oszillator (1), einem Frequenzteiler (4), der das frequenzgeteilte Signal (Fig. 2a) erzeugt, und einem Phasendetektor (39), der eine erste Vergleichsanordnung (10) zur Grobphasendetektion, eine zweite Vergleichsanordnung (19) zur Feinphasendetektion sowie eine Auswahlschaltung (31) umfaßt, die ein resultierendes Phasensignal, das dem Oszillator zum Steuern der Frequenz des Taktsignals zugeführt wird, im Falle großer Phasenabweichungen aus dem Grobphasenvergleich und im Falle geringer Phasenabweichungen aus dem Feinphasenvergleich ableitet, wird bei einem amplitudendiskreten Synchronisiersignal mit begrenzter zeitlicher Auflösung dennoch eine genaue Einstellung auf die Flanke F dadurch erreicht, daß das Synchronisiersignal (Fig. 2c) dem Phasendetektor (39) in Form einer Folge amplitudendiskreter Werte zugeführt wird, die durch Abtasten des Synchronisiersignals (Fig. 2c) mit dem Taktsignal gebildet wird, wobei für die Flanke (F) im Synchronisiersignal (Fig. 2c) eine aus reichende Anzahl Amplitudenstufen vorgesehen ist.

./...

FIG. 1

# Schaltungsanordnung zum Synchronisieren eines Signals

Die Erfindung bezieht sich auf eine Schaltungsanordnung zum Synchronisieren der Phase eines frequenzgeteilten Signals mit einer Flanke endlicher Steigung eines im wesentlichen periodischen Synchronisiersignals mit einem ein Taktsignal abgebenden Oszillator mit steuerbarer Frequenz, einem Frequenzteiler, der durch Teilen der Frequenz des Taktsignals durch eine ganze Zahl das frequenzgeteilte Signal erzeugt, und mit einem Phasendetektor, der umfaßt: eine erste Vergleichsanordnung zum Bestimmen des Phasenunterschieds zwischen einem Bezugszeitpunkt im frequenzgeteilten Signal und der Flanke des Synchronisiersignals und zur Abgabe eines ersten Phasensignals, das ein Maß für diesen Phasenunterschied ist, eine zweite Vergleichsanordnung zum Abtasten des Wertes des Synchronisiersignals im Bezugszeitpunkt und zur Abgabe eines aus diesem Wert gebildeten zweiten Phasensignals, sowie eine Auswahlschaltung, die ein resultierendes Phasensignal, das dem Oszillator zum Steuern der Frequenz des Taktsignals zugeführt wird, aus dem ersten Phasensignal ableitet, wenn dieses einen Grenzwert überschreitet, und die sonst das resultierende Phasensignal aus dem zweiten Phasensignal ableitet.

Eine derartige Schaltungsanordnung ist aus der DE-OS 28 02 626 als phasenverriegelte Schleife beispielsweise zum Verriegeln der Frequenz eines Oszillators auf einer Bezugsfrequenz bzw. einem Vielfachen oder einem Teil derselben bekannt. Die bekannte Schaltungsanordnung weist eine Phasenvergleichsanordnung zum Vergleichen der Phasen erster und zweiter Eingangssignale auf, die als im wesentlichen rechteck- bzw. trapezförmige, analoge Signale zugeführt werden. Die Phasendifferenz zwischen diesen beiden Signalen wird in einer ersten und einer zweiten Vergleichsanordnung gemessen, wobei die zweite Vergleichsanordnung einen Phasendifferenzbereich von weniger als 180° und die erste Vergleichsanordnung einen demgegenüber wesentlich größeren Phasendifferenzbereich aufweist. Falls der Phasenunterschied zwischen den Eingangssignalen größer ist als der Bereich der zweiten Vergleichsanordnung, leitet die bekannte Phasenvergleichsanordnung ein dem Phasenunterschied entsprechendes Ausgangssignal aus der ersten Vergleichsanordnung ab, wohingegen das Ausgangssignal aus der zweiten Vergleichsanordnung abgeleitet wird, wenn der Phasenunterschied in den Bereich der zweiten Vergleichsanordnung fällt. Auf diese Weise wird mit der ersten Vergleichsanordnung ein Grobphasenvergleich und mit der zweiten Vergleichsanordnung ein Feinphasenvergleich durchgeführt. Damit wird ein sicheres Verriegeln der phasenverriegelten Schleife aus beliebigen Phasenunterschieden der Eingangssignale heraus erreicht.

Grundsätzlich ist eine derartige Schaltungsanordnung auch dann vorteilhaft einsetzbar, wenn anstelle der analogen Eingangssignale digitale Signale in ihren Phasen verglichen werden sollen. Als digitale Signale sind dabei Signale zu verstehen, die aus einer zeitdiskreten Folge amplitudendiskreter Werte bestehen. Derartige digitale Signale sind in ihrer zeitlichen Auflösung durch die Folgefrequenz der amplitudendiskreten Werte beschränkt. Diese Folgefrequenz bestimmt auch die Auflösung für den Phasenvergleich, d.h. den geringsten noch feststellbaren Phasenunterschied zwischen den Eingangssignalen. Ist eine sehr genaue Bestimmung dieses Phasenunterschiedes erforderlich, müssen die Eingangssignale eine hohe zeitliche Auflösung durch Anwendung einer hohen Folgefrequenz für die amplitudendiskreten Werte aufweisen. Derartige hohe Folgefrequenzen bedingen jedoch hohe Signalverarbeitungsgeschwindigkeiten, d.h. hohe Taktraten, wozu steuernde Signale mit sehr hohen Frequenzen erforderlich sind. Derartig hochfrequente Signale sind jedoch mit den bekannten Schaltungsanordnungen nicht verarbeitbar.

Die Erfindung hat die Aufgabe, eine Schaltungsanordnung der eingangs genannten Art derart auszubilden, daß mit begrenzter zeitlicher Auflösung der Eingangssingale des Phasendetektors und damit niedriger Folgefrequenz der diese Signale darstellenden, amplitudendiskreten Werte dennoch eine genaue Detektion des Phasenunterschieds und damit ein genaues Synchronisieren mit der Flanke des Synchronisiersignals ermöglicht wird.

Dazu weist die erfindungsgemäße Schaltungsanordnung das Kennzeichen auf, daß das Synchronisiersignal dem Phasendetektor in Form einer Folge amplitudendiskreter Werte zugeführt wird, die durch Abtasten des Synchronisiersignals mit dem Taktsignal gebildet wird, wobei für die Flanke im Synchronisiersignal eine ausreichende Anzahl Amplitudenstufen vorgesehen ist.

Bei der erfindungsgemäßen Schaltungsanordnung wird das Synchronisiersignal von dem vom Oszillator gelieferten Taktsignal abgetastet. Das Taktsignal gibt dabei ein Zeitraster von Abtastzeitpunkten vor. Bei einer Veränderung der Phasenlage, d.h. des Phasenunterschiedes zwischen dem Synchronisiersignal einerseits und dem aus dem Taktsignal abgeleiteten frequenzgeteilten Signal andererseits verschiebt sich dieses Zeitraster kontinuierlich gegenüber dem Synchronisiersignal. Dadurch verändern sich auch die beim Abtasten des Synchronisiersignals gewonnenen amplitudendiskreten Werte, wobei die Auflösung für eine Detektion dieser Veränderung durch die Auflösung und damit die Anzahl der Amplitudenstufen für das Synchronisiersignal bestimmt wird.

Wird nun für die Flanke im Synchronisiersignal eine ausreichende Anzahl Amplitudenstufen vorgesehen, wird bereits eine geringe Verschiebung der Phasenlage zwischen dem analogen Synchronisiersignal und dem durch das Taktsignal vorgegebenen Zeitraster eine merkliche Veränderung der durch Abtasten der Flanke gewonnenen amplitudendiskreten Werte hervorrufen. Die Auflösung für die Detektion dieser Veränderung der Phasenlage kann gegebenenfalls durch Erhöhung der Anzahl der Amplitudenstufen verfeinert werden, ohne daß die Frequenz des Taktsignals und damit die Folgefrequenz des Abtast-Zeitrasters erhöht werden muß. Damit ist eine beliebig feine Auflösung bei fest vorgegebener Taktfrequenz möglich.

Der Aufbau des in der erfindungsgemäßen Schaltungsanordnung verwendeten Phasendetektors mit einer Grob- und einer Feindetektion ermöglicht es weiterhin, beim Auftreten eines im wesentlichen impulsförmigen Synchronisiersignals für beliebige Phasenlagen zwischen dem Synchronisiersignal und dem frequenzgeteilten Signal ein eindeutiges Phasensignal zum Steuern des Oszillators zu liefern, so daß ein Synchronisieren des Taktsignals mit dem Synchronisiersignal bei beliebigen Phasenabweichungen und auch bei Frequenzabweichungen zwischen dem Synchronisiersignal und dem frequenzgeteilten Signal erzielt wird. Das Abtasten eines impulsförmigen Synchronisiersignals in der zweiten Vergleichsanordnung liefert nämlich einen eindeutigen Wert nur im Bereich oder allenfalls noch einem kleinen Zeitintervall vor und nach der Flanke, mit der das Taktsignal zu Synchronisieren ist. In der Regel nimmt nämlich ein derartiges Synchronisiersignal einen bestimmten Wert zu mehreren Zeitpunkten innerhalb einer Periodendauer an. Für eine eindeutige, d.h. phasenstarre Synchronisierung muß jedoch sichergestellt sein, daß beispielsweise stets der Wert auf der Vorderflanke des Impulses ausgewählt wird. Der Meßbereich der zweiten Vergleichsanordnung für die Feinphasendetektion erstreckt sich daher im wesentlichen über die Flanke im Synchronisiersignal, wohingegen sich der Meßbereich der ersten Vergleichsanordnung für die Grobphasendetektion über wenigstens eine Periode des Synchronisiersignals bzw. des frequenzgeteilten Signals erstreckt.

Die Auswahlschaltung nimmt eine Umschaltung zwischen der Grob-Phasendetektion in der ersten Vergleichsanordnung und der Fein-Phasendetektion in der zweiten Vergleichsanordnung vor. Dazu wird der Wert des ersten Abtastsignals mit dem Grenzwert verglichen. Dieser ist derart gewählt, daß das zweite Abtastsignal einen eindeutigen Wert annimmt und somit ein eindeutiges Phasensignal zum Steuern des Oszillators liefert, wenn das erste Abtastsignal den Grenzwert unterschreitet.

An dieser Stelle sei der Vollständigkeit halber erwähnt, daß aus der DE-OS 32 39 933 eine Schaltungsanordnung bekannt ist, bei der einem Phasendetektor ein Wechselstromsignal, insbesondere das Farbsynchronsignal in einem Farbfernsehempfänger, als Synchronisiersignal und ein Bezugssignal, vorzugsweise etwa gleicher Frequenz, zugeführt werden. Der Phasendetektor bildet aus dem Vergleich der ihm zugeführten Signale ein Regelsignal, das über einen PI-Regler und einen Analog-Digital-Umsetzer einem steuerbaren Oszillator zum Steuern der Frequenz eines von ihm abgegebenen Taktsignals zugeführt wird. Das Taktsignal wird in einer dem steuerbaren Oszillator nachgeschalteten Impulsformungsstufe in seiner Frequenz auf die Frequenz des Bezugssignals heruntergeteilt. Aus dem so erhaltenen frequenzgeteilten Signal wird das dem Phasendetektor zugeleitete Bezugssignal gewonnen. In dieser Schaltungsanordnung ist das Taktsignal vom steuerbaren Oszillator in seiner Frequenz und Phase an das dem Phasendetektor zugeführte Wechselstromsignal gekoppelt.

In dem Phasendetektor in der Schaltungsanordnung aus der DE-OS 32 39 933 wird das als Synchronisiersignal zugefürte Wechselstromsignal zu bestimmten Zeitpunkten abgetastet, die durch eine symmetrische Rechteckschwingung bestimmt werden, deren Frequenz dem Vierfachen der Frequenz des als Vergleichssignal zugeführten Bezugssignals entspricht. Aus diesen Abtastwerten bildet der Phasendetektor durch bestimmte Verknüpfungen das dem Oszillator zugeleitete Regelsignal. Da es sich bei dem Wechselstromsignal um ein Signal mit einem bestimmten zeitlichen Verlauf, nämlich um ein sinusförmiges Signal, handelt, wird durch die Verknüpfungen der Abtastwerte des Wechselstromsignals stets ein eindeutiges Regelsignal erhalten.

Liegt dagegen ein im wesentlichen impulsförmiges Synchronisiersignal vor, beispielsweise ein in einem Fernsehsignal enthaltenes Zeilensynchronsignal, dem gegebenenfalls Reste eines Bildsignals überlagert sind, liefert die genannte Schaltungsanordnung kein eindeutiges Regelsignal.

Nach einer Weiterbildung der Erfindung wird das resultierende Phasensignal nach Überschreiten des Grenzwertes durch das erste Phasensignal erst dann aus diesem abgeleitet, wenn es den Grenzwert innerhalb eines bestimmten Zeitintervalls nach Auftreten der jeweils letzten Flanke im Synchonisiersignal überschreitet.

Beim Auftreten starker Störungen im Synchronisiersignal kann es vorkommen, das diese von der ersten Vergleichsanordnung fälschlich als Flanken erkannt werden und daß demzufolge beim Auftreten einer derartigen Störung ein fehlerhaftes erstes Phasensignal gebildet wird, das den Grenzwert überschreitet und somit der Auswahlschaltung eine fehlerhafte Synchronisation vortäuscht. Dadurch kann die Schaltungsanordnung aus dem synchronisierten Zustand gebracht werden. Zur Erhöhung der Störsicherheit wird daher im synchronisierten Zustand der Schaltungsanordnung, d.h. in dem Zustand, in dem die Feinphasendetektion wirksam ist, ein den Grenzwert überschreitendes erstes Phasensignal nur dann die Auswahlschaltung beeinflussen und damit die Grobphasendetektion in Funktion setzen, wenn die Abschnitte im Synchronisiersignal, die als Flanken erkannt werden, im wesentlichen mit der Periode des Synchronisiersignals auftreten. Anders ausgedrückt:
Es wird, jeweils gerechnet von der letzten Flanke im Synchronisiersignal an, ein Zeitintervall in der Art eines Zeitfensters festgelegt, innerhalb dessen die nächste Flanke des Synchronisiersignals auftreten muß. Die nächste, in diesem Intervall auftretende Flanke im Synchronisiersignal wird dann als solche erkannt, während alle Signalteile, die außerhalb dieses Zeitintervalls liegen, nicht als Flanke erkannt werden können. Damit werden alle Störungen außerhalb des Zeitintervalls unterdrückt. Die Größe des Zeitintervalls kann darüber hinaus veränderbar sein.

Befindet sich die Schaltungsanordnung in dem Zustand, in dem die Grobphasendetektion wirksam ist, wird vorzugsweise jede Flanke im Synchronisiersignal ausgewertet, die vorstehend genannte Störunterdrückung also unwirksam geschaltet, um das Synchronisieren zu beschleunigen, bis wiederum die Feinphasenregelung wirksam ist.

Nach einer weiteren Ausgestaltung der Erfindung umfaßt die erste Vergleichsanordnung einen Signalgenerator zum Abgeben eines im wesentlichen rampenförmigen Vergleichssignals, sowie einen Flankendetektor und eine erste Abtast- und Halteschaltung zum Speichern des augenblicklichen Wertes des rampenförmigen Vergleichssignals und zum Abgeben dieses Wertes als erstes Phasensignal, wenn der Flankendetektor die Flanke im Synchronisiersignal detektiert. Da bei einem rampenförmigen Signal ein eindeutiger, unmittelbarer Zusammenhang zwischen dem Signalwert und der Phase besteht, wird mit einer derart ausgebildeten ersten Vergleichsanordnung auf einfache Weise ein erstes Phasensignal und damit ein Phasensignal erzeugt, das ein direktes Maß für die Phasenlage zwischen dem Vergleichssignal und der Flanke darstellt. Das rampenförmige Signal hat bevorzugt einen amplitudendiskreten, stufenförmigen Verlauf mit einem durch die Periode des Taktsignals bestimmten zeitlichen Stufenabstand.

Nach einer weiteren Ausgestaltung der Erfindung ist der Bezugszeitpunkt durch einen Durchgang des Vergleichssignals durch einen Bezugswert bestimmt und umfaßt die zweite Vergleichsanordnung einen Bezugswertdurchgangsdetektor und eine zweite Abtast- und Halteschaltung zum Speichern des augenblicklichen Wertes des Synchronisiersignals und zum Abgeben dieses Wertes als zweites Phasensignal, wenn der Bezugswertdurchgangsdetektor einen Durchgang des Vergleichssignals durch den Bezugswert detektiert. Der Bezugswert legt einen eindeutigen Zeitpunkt bzw. eine eindeutige Phasenlage innerhalb der Periode des Vergleichssignals und damit eine bestimmte Phasenlage in dem vom Oszillator abgegebenen Taktsignal fest, die mit der Flanke im Synchronisiersignal zusammenfallen soll. Diese Phasenlage bzw. dieser Zeitpunkt kann jedoch auch unmittelbar aus dem frequenzgeteilten Signal abgeleitet werden, wobei die feste Zuordnung zu dem Bezugswert erhalten bleibt. Die zweite Abtast- und Halteschaltung wird dann unmittelbar mit dem frequenzgeteilten Signal angesteuert, der Bezugswertdurchgangsdetektor kann dann entfallen. Bei einer derartigen Ausbildung der Schaltungsanordnung müssen jedoch gegebenenfalls Signallaufzeiten im Signalgenerator und im Bezugswertdurchgangsdetektor berücksichtigt werden.

Nach einer weiteren Fortbildung der Erfindung ist der zweiten Vergleichsanordnung an einem Synchronisiereingang eine Nullpunkteinstellanordnung vorgeschaltet, über die das Synchronisiersignal der zweiten Vergleichsanordnung zugeleitet wird. Damit kann der Nullpunkt des Synchronisiersignals eingestellt und so beispielsweise dem zweiten Phasensignal ein konstanter Wert überlagert werden. Auch kann die Nullpunkteinstellanordnung eine Vorrichtung enthalten, die die Impulsamplituden des Synchronisiersignals abtastet und in Abhängigkeit davon den Nullpunkt des Synchronisiersignals neu festlegt. Insbesondere kann der Nullpunkt auf einen bestimmten Punkt der Flanke des Synchronisiersignals, beispielsweise in der Mitte, eingestellt werden. Der Flankendetektor kann dann vorzugsweise als Nulldurchgangsdetektor ausgebildet sein, der einen Vorzeichenwechsel in einer bestimmten Richtung des Synchronisiersignals detektiert. Das Taktsignal wird dann auf den Zeitpunkt des Nulldurchgangs des Synchronisiersignals synchronisiert.

Nach einer weiteren Ausgestaltung der Erfindung ist zwischen die Auswahlschaltung und die erste Vergleichsanordnung eine Steilheitanpaßschaltung zum aneinander Angleichen der Steigungen des rampenförmigen Vergleichssignals und der Flanke des Synchronisiersignals geschaltet, über die das erste Phasensignal der Auswahl-

0174049

schaltung zugeleitet wird. Dadurch wird die Steilheit des ersten Phasensignals, d.h. dessen Änderung über der Phase, der Steilheit des zweiten Phasensignals angepaßt. So wird insbesondere bei einer sehr steilen Flanke im Synchronisiersignal die Steilheit des zweiten Phasensignals, d.h. dessen Veränderung über der Phase, sehr groß, während das erste Phasensignal eine geringe Steilheit aufweist, insbesondere dann, wenn es nur über einen begrenzten Wertebereich verfügt und über eine ganze Periode des Synchronisiersignals eine konstante Steilheit aufweisen soll. Die Steilheitsanpaßschaltung kann derart ausgebildet sein, daß das erste Phasensignal mit einem festen Multiplikationsfaktor multipliziert wird, jedoch kann dieser Multiplikationsfaktor auch veränderbar sein und beispielsweise in seinem Wert durch die Amplitude des Synchronisiersignals gesteuert werden.

Nach einer anderen Ausgestaltung der Erfindung werden der Frequenzteiler und der Signalgenerator durch einen gemeinsamen, vom Taktsignal fortgeschalteten Zähler gebildet. Das vom Frequenzteiler abgegebene frequenzgeteilte Signal und das vom Signalgenerator abgegebene, rampenförmige Vergleichssignal sind dann stets unmittelbar miteinander verkoppelt, da beide unmittelbar aus den Stellungen des Zählers ableitbar sind. Der Frequenzteiler und der Signalgenerator umfassen insbesondere dem Zähler nachgeschaltete Stufen, in denen bestimmte Zählerstellungen detektiert werden. Auch kann ein gesonderter Signalgenerator entfallen, und die Stellungen des Zählers können unmittelbar als digitales rampenförmiges Signal herangezogen werden. Bei einer derartigen Ausgestaltung der erfindungsgemäßen Schaltungsanordnung liegt auch das resultierende Phasensignal in der Form eines digitalen Signals vor.

Nach einer weiteren Ausgestaltung der erfindungsgemäßen
Schaltungsanordnung zur Verwendung in einer Anordnung zum
Gewinnen einer Folge amplitudendiskreter Fernsehsignalwerte aus einem analogen Fernsehsignal ist das Synchronisiersignal ein im Fernsehsignal enthaltenes Zeilensynchronsignal, dient das Taktsignal zum Gewinnen der
amplitudendiskreten Fernsehsignalwerte und leitet der
Frequenzteiler aus dem frequenzgeteilten Signal Horizontalsynchronimpulse ab. In einer derartigen Anordnung wird
vorteilhaft das Taktsignal, das die Folgefrequenz der aus
dem analogen Fernsehsignal durch Abtasten gewonnenen Folge
amplitudendiskreter Werte bestimmt, in seiner Frequenz auf
ein ganzzahliges Vielfaches des Zeilensynchronsignals
festgelegt. Es ist daher zweckmäßig und mit der
erfindungsgemäßen Schaltungsanordnung auf vorteilhafte
Weise erreichbar, das Taktsignal mit dem Zeilensynchronsignal zu synchronisieren. Dabei wird das Zeilensynchronsignal als analoges Signal zugeführt, das durch Abtasten
mit dem Taktsignal und Quantisierung in  ein digitales
Signal umgesetzt wird, das aus einer taktfrequenten Folge
amplitudendiskreter Werte besteht. Der Frequenzteiler
teilt vorzugsweise die Frequenz des Taktsignals auf die
Frequenz des Zeilensynchronsignals herunter, so daß das
frequenzgeteilte Signal mit dem Zeilensynchronsignal aus
dem Fernsehsignal synchronisiert ist. Aus dem frequenzgeteilten Signal können in einfacher Weise als aufbereitetes Zeilensynchronsignal für die weitere Signalverarbeitung, beispielsweise in einer Bildwiedergabevorrichtung, Horizontalsynchronimpulse abgeleitet werden,
die unmittelbar mit dem Taktsignal und damit der ein
digitales Fernsehsignal bildenden Folge von amplitudendiskreten Fernsehsignalwerten verkoppelt sind, die aus dem
analogen Fernsehsignal durch Abtasten gebildet werden.

Nach einer weiteren Ausgestaltung der Erfindung wird das Phasensignal über einen Digital-Analog-Umsetzer dem Oszillator zugeleitet. Dadurch wird das digitale Phasensignal in ein analoges Signal, beispielsweise eine analoge Steuerspannung, zum Steuern des Oszillators umgesetzt, der dann in der an sich bekannten Art eines spannungsgesteuerten Oszillators aufgebaut sein kann. Das Phasensignal wird dem Oszillator bevorzugt über ein Schleifenfilter zugeführt, das beispielsweise als PI-Regler ausgebildet ist. Dadurch kann das Regelverhalten der Schaltungsanordnung beeinflußt werden. Das Schleifenfilter kann als analoges Filter hinter dem Digital-AnalogUmsetzer oder insbesondere als digitales Filter davor in den Weg des Phasensignals eingefügt werden.

Nach einer weiteren Fortbildung der Erfindung wird das Phasensignal dem Oszillator über ein Interpolationsfilter zugeleitet.

Bei der erfindungsgemäßen Schaltungsanordnung wird in jeder Periode des Synchronisiersignals nur ein Wert für das resultierende Phasensignal gebildet, da die Vergleichsanordnungen in jeder Periode des Synchronisiersignals nur je einen Wert für das erste und zweite Phasensignal erzeugen. Dieser eine Wert des resultierenden Phasensignals bestimmt dann die Frequenz des Taktsignals für die Dauer der zugehörigen Periode des Synchronisiersignals. Dadurch können insbesondere im nicht synchronisierten Zustand der Schaltungsanordnung zwischen aufeinander folgenden Werten des resultierenden Phasensignals große Sprünge auftreten, die zu großen Sprüngen in der Frequenz und/oder Phase des Taktsignals führen. Wenn das Taktsignal beispielsweise für die Verarbeitung eines digitalen Fernsehsignals verwendet wird, können sich derartige Frequenz- und/oder Phasensprünge nachteilig auf die Bildqualität auswirken.

Das Interpolationsfilter, das in den Signalweg des resultierenden Phasensignals vom Phasendetektor zum Oszillator geschaltet ist, wandelt Sprünge im resultierenden Phasensignal in stetige Phasensignaländerungen, beispielweise in Rampenform, um. Ein derartiges Interpolationsfilter ist beispielsweise als analoge Schaltung mit tiefpaßähnlichem Signalübertragungsverhalten oder bevorzugt als digitale Schaltung aufgebaut, die für eine Reihe von Zeitpunkten innerhalb einer Periode zwischen zwei abgetasteten Flanken des Synchronisiersignals gemäß der Lage der Zeitpunkte gewichtete Mittelwerte zwischen zwei aufeinander folgenden Werten des vom Phasendetektor abgegebenen resultierenden Phasensignals berechnet. Damit wird der zunächst stufenförmige Verlauf des resultierenden Phasensignals am Ausgang des Phasendetektors durch zusätzliche Werte ergänzt, die je nach ihrer Anzahl pro Periode des Synchronisiersignals einen stetigen und insbesondere einen linearen Verlauf für das resultierende Phasensignal annähern. Ein derartiges Interpolationsfilter kann auf einfache Weise durch das Taktsignal gesteuert werden, wodurch eine gleichmäßige Unterteilung der Periode des Synchronisiersignals gewährleistet ist. Die Folgefrequenz der vom Interpolationsfilter abgegebenen, interpolierten Werte für das resultierende Phasensignal kann somit in weiten Bereichen bis hinauf zu der Frequenz des Taktsignals festgelegt werden. Auch ein umschaltbares Interpolationsfilter mit verschiedenen, wählbaren Folgefrequenzen kann aufgebaut werden.

Ausführungsbeispiele der Erfindung sind in der Zeichnung dargestellt und werden im nachfolgenden näher beschrieben. Es zeigen

Fig. 1 ein Blockschaltbild für ein einfaches Ausführungsbeispiel,

Fig. 2 einige Signalverläufe aus der Schaltungsanordnung
nach Fig.1,

Fig. 3 ein Blockschaltbild eines weiteren
Ausführungsbeispiels,

Fig. 4 eine Abwandlung der Schaltungsanordnung nach Fig.
3,

Fig. 5 ein etwas detaillierteres Blockschaltbild eines
Teils der Schaltungsanordnung nach Fig.4.

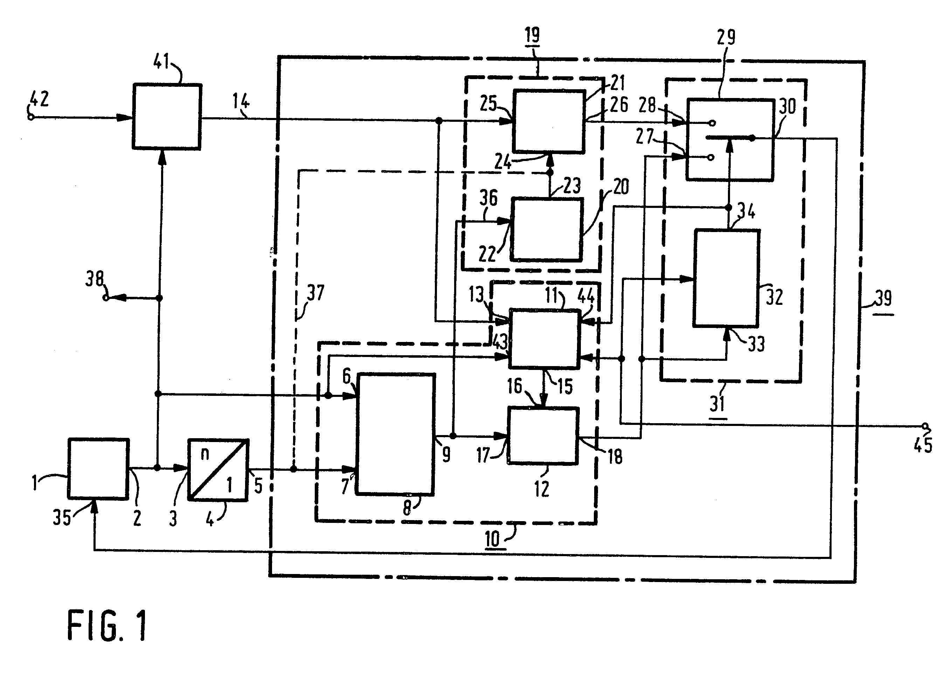

Fig. 1 zeigt ein Blockschaltbild eines ersten, einfachen
Ausführungsbeispiels der erfindungsgemäßen Schaltungsanordnung. Ein Oszillator 1 gibt an einem Ausgang 2 ein
Taktsignal mit beispielsweise sinus- oder bevorzugt rechteckförmigem Verlauf ab. Das Taktsignal wird einem Eingang
3 eines Frequenzteilers 4 zugeführt, der es in seiner
Frequenz durch eine ganze Zahl teilt und an seinem Ausgang
5 ein frequenzgeteiltes Signal abgibt, das vorzugsweise
einen rechteckförmigen Verlauf aufweist.

Das Taktsignal vom Ausgang 2 des Oszillators 1 und das
frequenzgeteilte Signal vom Ausgang 5 des Frequenzteilers
4 werden einem ersten und einem zweiten Eingang 6, 7 eines
Signalgenerators 8 zugeführt, der daraus ein in jeweils
einer Periode eines Synchronisiersignals eindeutiges Vergleichssignal ableitet und an einem Ausgang 9 abgibt. Das
Vergleichssignal weist vorzugsweise einen rampenförmigen
Verlauf auf mit einer über der gesamten Periode des Synchronisiersignals gleichförmigen Steigung, es kann jedoch
auch ein Signal mit innerhalb einer Periode variierender
Steigung abgegeben werden. Signalgeneratoren zur Erzeugung
derartiger Vergleichssignale sind im Prinzip bekannt. Bei
der vorliegenden Schaltungsanordnung wird vorzugsweise ein
Signalgenerator verwendet, der eine ein rampenförmiges
Signal annähernde Folge amplitudendiskreter Werte mit
einer durch das Taktsignal bestimmten Folgefrequenz und einem vom frequenzgeteilten Signal bestimmten Rampenanfang abgibt. Gegebenenfalls kann ein Signalgenerator auch derart ausgeführt sein, daß ihm nur das Taktsignal am ersten Eingang 6 zugeleitet werden muß.

Der Signalgenerator 8 ist Teil einer ersten Vergleichsanordnung 10, die in der Fig. 1 durch eine gestrichelte Linie umgeben ist und die außer dem Signalgenerator 8 einen Flankendetektor 11 und eine erste Abtast- und Halteschaltung 12 umfaßt. Dem Flankendetektor 11 wird an einem Eingang 13 das Synchronisiersignal vom Synchronisiersignalanschluß 14 zugeführt. Beim Auftreten einer Flanke im Synchronisiersignal, mit der das Taktsignal synchronisiert werden soll, gibt der Flankendetektor 11 an einem Ausgang 15 ein erstes Schaltsignal ab, das dem Schaltsignaleingang 16 der ersten Abtast- und Halteschaltung 12 zugeleitet wird. Beim Auftreten des ersten Schaltsignals tastet die erste Abtast- und Halteschaltung 12 den Wert des ihr über einen Vergleichssignaleingang 17 zugeführten Vergleichssignals ab und stellt diesen an einem Ausgang 18 für die Dauer einer Periode des Synchronisiersignals als erstes Phasensignal bereit, d.h. bis zum Auftreten der nächsten Flanke im Synchronisiersignal, die im Flankendetektor 11 die Bildung eines ersten Schaltsignals auslöst.

Die Schaltungsanordnung nach Fig. 1 enthält weiterhin eine zweite Vergleichsanordnung 19, die durch eine gestrichelte Linie angedeutet ist und die einen Bezugswertdurchgangsdetektor 20 sowie eine zweite Abtast- und Halteschaltung 21 umfaßt. Dem Bezugswertdurchgangsdetektor 20 wird an einem Eingang 22 das Vergleichssignal vom Ausgang 9 des Signalgenerators 8 zugeleitet. Er gibt an einem Ausgang 23 ein zweites Schaltsignal ab, wenn das Vergleichssignal in einem Bezugszeitpunkt t0 einen bestimmten Bezugswert B durchläuft. Dieser Bezugswert B kann auf einen beliebigen Wert zwischen dem größtmöglichen und dem kleinstmöglichen Wert des Vergleichssignals festgelegt werden. Beispielsweise wird der Bezugswert bei einem rampenförmigen Vergleichssignal in die Mitte des rampenförmigen Verlaufs gelegt. Durch das vom Ausgang 23 einem Schaltsignaleingang 24 der zweiten Abtast- und Halteschaltung 21 zugeleitete zweite Schaltsignal wird zum Zeitpunkt des Durchlaufens des Vergleichssignals durch den Bezugswert der Wert des Synchronisiersignals, das vom Synchronisiersignalanschluß 14 einem Synchronisiersignaleingang 25 der zweiten Abtast- und Halteschaltung 21 zugeführt wird, in dieser abgetastet und an einem Ausgang 26 als zweites Phasensignal bereitgestellt, bis der Bezugswertdurchgangsdetektor 20 erneut ein zweites Schaltsignal abgibt.

Der vom Ausgang 18 der ersten Abtast- und Halteschaltung 12 als erstes Phasensignal abgegebene Wert des Vergleichssignals und das zweite Phasensignal vom Ausgang 26 der zweiten Abtast- und Halteschaltung 21 werden einem ersten bzw. einem zweiten Eingang 27, 28 einer Umschaltvorrichtung 29 zugeführt, die einen Ausgang 30 aufweist, der wahlweise mit dem ersten Eingang 27 oder dem zweiten Eingang 28 verbindbar ist. Die Umschaltvorrichtung 29 ist Teil einer Auswahlschaltung 31, die in Fig. 1 durch eine gestrichelte Linie angedeutet ist und außer der Umschaltvorrichtung 29 einen Grenzwertdetektor 32 umfaßt, dem an einem Eingang 33 das erste Phasensignal vom Ausgang 18 der ersten Abtast- und Halteschaltung 12 zugeführt wird und der an einem Ausgang 34 ein Auswahlsignal abgibt, durch das die Umschaltvorrichtung 29 umgeschaltet wird derart, daß der erste Eingang 27 mit dem Ausgang 30 verbunden ist, wenn der Betrag des ersten Phasensignals einen durch den Grenzwertdetektor 32 vorgegebenen Grenzwert überschreitet, und daß der zweite Eingang 28 mit dem Ausgang 30 verbunden ist, wenn das erste Phasensignal den Grenzwert unterschreitet.

Vom Ausgang 30 der Umschaltvorrichtung 29 wird das jeweils anliegende erste oder zweite Phasensignal als resultierendes Phasensignal einem Steuereingang 35 des Oszillators 1 zum Steuern der Frequenz des Taktsignals zugeführt.

Fig. 2 zeigt einige Signalverläufe zur Wirkungsweise der Schaltungsanordnung nach Fig. 1. In Fig. 2a ist als Beispiel für ein frequenzgeteiltes Signal ein rechteckförmiges Signal dargestellt, wie es am Ausgang 5 des Frequenzteilers 4 abgegeben wird, während in Fig. 2b ein daraus vom Signalgenerator 8 abgeleitetes und an seinem Ausgang 9 abgegebenes, rampenförmiges Vergleichssignal dargestellt ist. Dargestellt ist in den Fig. 2a und 2b jeweils eine Periode der Signale zwischen den Zeitpunkten t1 und t2, die mit jeweils einer ansteigenden Flanke des frequenzgeteilten Signals zusammenfallen. In der Mitte dieser Periode, zum als Bezugszeitpunkt t0 dienenden Zeitpunkt einer abfallenden Flanke im frequenzgeteilten Signal, durchläuft das rampenförmige Vergleichssignal nach Fig. 2b den Bezugswert B. Durch Verändern des Bezugswerts B kann in einem anderen Beispiel jedoch auch ein anderer Bezugszeitpunkt t0 im Intervall zwischen t1 und t2 ausgewählt werden.

In Fig. 2c ist ein Beispiel für einen Verlauf eines über den Synchronisiersignalanschluß 14 zugeführten Synchronisiersignals während einer seiner Perioden wiedergegeben. Es handelt sich bei diesem Beispiel um ein aus einem Fernsehsignal gewonnenes Signal, das außer Impulsen I noch Reste eines Bildsignals Y umfaßt. Die Impulse I sollen mit Mittelwerten M ihrer vorderen Flanken F die vom Oszillator 1 abgegebene Schwingung synchronisieren. Die Mittelwerte M liegen dabei auf halber Impulshöhe zwischen einem Grundwert G und dem Scheitel A der Impulse I.

Zum Zeitpunkt t3, in dem das Synchronisiersignal mit der synchronisierenden Flanke F den Mittelwert M durchläuft, wird durch das vom Flankendetektor 11 abgegebene erste Schaltsignal in der ersten Abtast- und Halteschaltung 12 der augenblickliche Wert des Vergleichssignals nach Fig. 2b abgetastet. Der Wert des so ermittelten ersten Phasensignals ist in Fig. 2b mit S1 bezeichnet. Der Wert S1 ist direkt proportional der Phasenabweichung P zwischen dem Durchgang des Vergleichssignals durch den Bezugswert B und dem Durchgang der Flanke F des Synchronisiersignals durch den Mittelwert M und damit direkt proportional der Zeitdifferenz t0 - t3. Der Wert S1 wird nun als resultierendes Phasensignal dem Oszillator 1 über den Steuereingang 35 solange zugeführt, bis durch Veränderung der Frequenz des Taktsignals die Phasenlage des frequenzgeteilten Signals und damit des Vergleichssignals gegenüber dem Synchronisiersignal so weit verändert ist, daß die Phasenabweichung P in die Größenordnung beispielsweise der halben Abfallzeit der Flanke F der Impulse I im Synchronisiersignal gelangt. Der Grenzwert im Grenzwertdetektor 32 ist derart gewählt, daß jetzt die Umschaltvorrichtung 29 umgeschaltet und im folgenden das zweite Phasensignal als resultierendes Phasensignal dem Oszillator 1 zugeleitet wird. Beispielsweise durchläuft das Synchronisiersignal, wie in Fig. 2d dargestellt, mit seiner Flanke F den Mittelwert M zum Zeitpunkt t4, der noch geringfügig später liegt als der Zeitpunkt t0. Die Phasenabweichung P wird jetzt durch die Differenz t4 - t0 bestimmt. Entsprechend dieser Phasenabweichung P tastet die zweite Abtast- und Halteschaltung 21 zum Zeitpunkt t0 des Durchgangs des Vergleichssignals nach Fig. 2b den Wert S2 an der Flanke F ab und gibt diesen als zweites Phasensignal über die Umschaltvorrichtung 29 an den Oszillator 1 weiter, der dadurch derart gesteuert wird, daß die Phasenabweichung P verschwindet und somit der Durchgang der Flanke F durch

0174049

den Mittelwert M zum Zeitpunkt t0 erfolgt. Das frequenzgeteilte Signal nach Fig. 2a und damit das Taktsignal sind so auf die Flanke F des Synchronisiersignals synchronisiert.

In der Schaltungsanordnung nach Fig. 1 kann der Bezugswertdurchgangsdetektor 20 eingespart werden, wenn dem Schaltsignaleingang 24 der zweiten Abtast- und Halteschaltung 21 unmittelbar ein frequenzgeteiltes Signal mit einem zeitlichen Verlauf gemäß Fig. 2a zugeführt wird, bei dem beispielsweise eine fallende Flanke als Schaltflanke mit dem Durchlauf des Vergleichssignals durch den Bezugswert B im Bezugszeitpunkt t0 zeitlich zusammenfällt. Die Leitung 36 zwischen dem Ausgang 9 und dem Eingang 22 und die Leitung zwischen dem Ausgang 23 und dem Eingang 24 können dann aufgetrennt werden, und statt dessen wird der Ausgang 5 des Frequenzteilers 4 durch die gestrichelt gezeichnete Verbindungsleitung 37 mit dem Schaltsignaleingang 24 der zweiten Abtast- und Halteschaltung 21 verbunden.

Das mit der Flanke F des Synchronisiersignals synchronisierte Taktsignal wird in der Schaltungsanordnung nach Fig. 1 vom Ausgang 2 des Oszillators 1 einem Ausgangsanschluß 38 zugeführt, von dem es weiteren, nicht dargestellten Stufen für eine mit ihm verkoppelte oder durch es gesteuerte Verarbeitung von Signalen zugeleitet werden kann. Ferner sind in Fig. 1 die erste und die zweite Vergleichsanordnung 10, 19 sowie die Auswahlschaltung 31 zu einem durch eine strichpunktierte Linie angedeuteten Phasendetektor 39 zusammengefaßt.

Die Signale nach Fig. 2 sind der einfachen Darstellung halber als analoge Signale gezeichnet, und die Schaltungsanordnung nach Fig. 1 ist anhand dieser Signale wie eine analoge Schaltung beschrieben worden. Die Schaltungsanordnung ist jedoch bevorzugt als digitale Schaltung ausgebildet, der über den Synchronisiersignalanschluß 14 ein digitales Synchronisiersignal zugeleitet wird, das aus einer Folge amplitudendiskreter Werte besteht, die in einem Analog-Digital-Umsetzer 41 durch Abtasten und Quantisieren eines über einen Eingang 42 zugeführten analogen Synchronisiersignals mit dem über den Ausgangsanschluß 38 zugeleiteten Taktsignal erzeugt werden. Der in Fig. 2c als analoges Signal dargestellte Verlauf des Synchronisiersignals und auch der Verlauf des rampenförmigen Vergleichsignals nach Fig. 2b werden dann durch einen stufenförmigen Verlauf angenähert, wobei die Länge der einzelnen Stufe einer Periode des Taktsignals entspricht und ihre Höhe durch die Zahl der Amplitudenstufen des digitalen Synchronisiersignals bestimmt ist.

Die Schaltungsanordnung aus Fig. 1 enthält ferner eine Einrichtung zur Unterdrückung von Störimpulsen im Synchronisiersignal, die im wesentlichen im Flankendetektor 11 enthalten ist. Dem Flankendetektor 11 wird dazu an einem Taktsignaleingang 43 das Taktsignal und an einem Auswahlsignaleingang 44 das Auswahlsignal vom Ausgang 34 des Grenzwertdetektors 32 zugeführt. Die Einrichtung zur Unterdrückung von Störimpulsen bewirkt nun insbesondere, daß im Flankendetektor 11 im Betriebszustand der Feinphasendetektion, d.h. wenn das zweite Phasensignal S2 dem Oszillator 1 als resultierendes Phasensignal zugeleitet wird, nur solche Flanken im Synchronisiersignal ausgewertet werden, die im Abstand einer Periode des störungsfreien Synchronisiersignals auftreten. Dazu wird beispielsweise das Synchronisiersignal nach Auftreten einer Flanke erst wieder im Bereich eines Zeitfensters ausgewertet, das in einem bestimmten Toleranzbereich um den Zeitpunkt angeordnet ist, in dem die nächste reguläre Flanke auftreten muß. Damit werden alle außerhalb dieses Zeitfensters liegenden Störflanken im Synchronisiersignal unterdrückt.

Dem Flankendetektor 11 und dem Grenzwertdetektor 32 wird ferner über eine Stellsignalleitung 45 ein Stellsignal zugeführt, mit dem beispielsweise die Größe des Zeitfensters verändert und entsprechend im Grenzwertdetektor 32 der Grenzwert eingestellt werden kann. Auch kann über die Stellsignalleitung 45 die Einrichtung zur Unterdrückung von Störimpulsen völlig unwirksam geschaltet werden. Damit läßt sich die Schaltungsanordnung nach Fig. 1 weitgehend an Art und Umfang von im Synchronisiersignal enthaltenen Störungen anpassen.

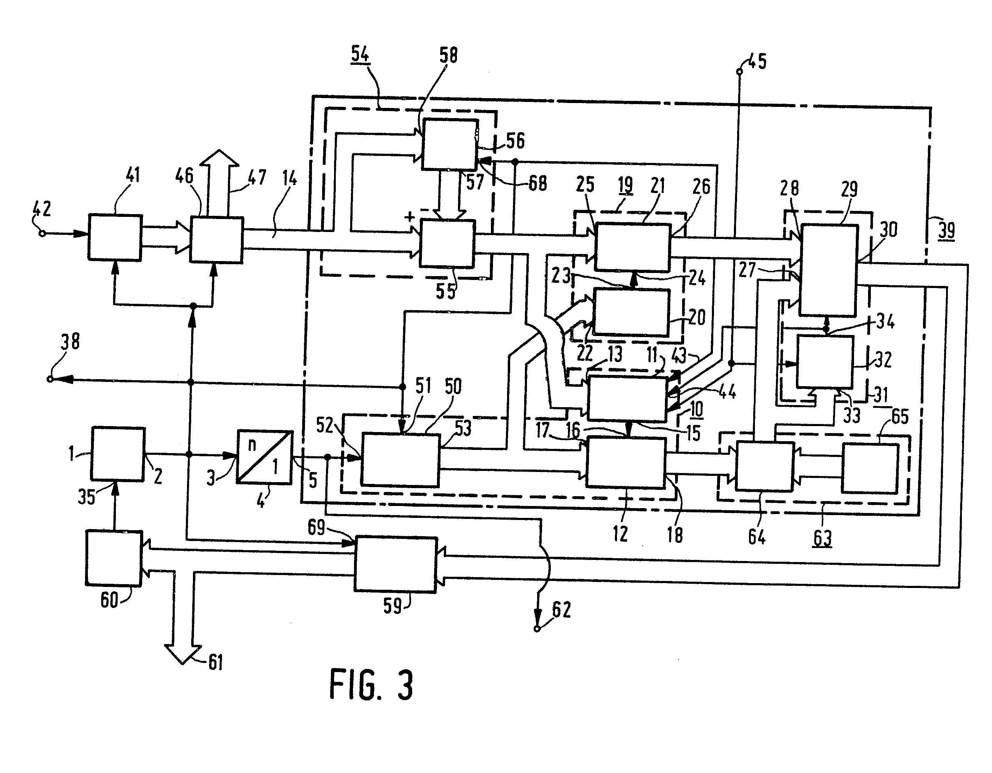

Fig. 3 zeigt ein weiteres Ausführungsbeispiel der erfindungsgemäßen Schaltungsanordnung. Einzelheiten der Schaltungsanordnung nach Fig. 3, die denen aus Fig. 1 entsprechen, sind mit gleichen Bezugszeichen versehen. Digitale Signale, die in der Schaltungsanordnung nach Fig. 3 verarbeitet werden, liegen in paralleler Form als binäre Signale, insbesondere als Dualzahlen, vor.

Als Signalgenerator 8 wird in der Schaltungsanordnung nach Fig. 3 ein Zähler 50 verwendet, dem an einem Zähleingang 51 das Taktsignal und an einem Steuereingang 52 das frequenzgeteilte Signal vom Ausgang 5 des Frequenzteilers 4 zugeführt wird. Der Zähler 50 zählt die Perioden des Taktsignals von einer Anfangsstellung an, in die er, gesteuert durch das frequenzgeteilte Signal am Steuereingang 52, zu Beginn einer jeden Periode des frequenzgeteilten Signals zurückgestellt wird. Bei einem rechteckförmigen frequenzgeteilten Signal erfolgt das Rücksetzen des Zählers vorzugsweise mit einem Sprung im Signalverlauf, wie er beispielsweise in Fig. 2a in den Zeitpunkten t1 und t2 auftritt. Gegebenenfalls kann das Zurücksetzen des Zählers 50 durch das frequenzgeteilte Signal entfallen, wenn der Zähler 50 eine eigene Vorrichtung zum Rücksetzen in die Anfangsstellung nach Durchlaufen einer Anzahl von Zählerstellungen umfaßt, die durch die Zahl bestimmt wird, durch die die Frequenz des Taktsignals im Frequenzteiler 4 geteilt wird.

Am Ausgang 53 des Zählers 50 erscheint die Zählerstellung in Form eines digitalen Signals, das unmittelbar als rampenförmiges Vergleichssignal verwendet wird. Der Verlauf des Vergleichssignals am Ausgang 53 des Zählers 50 entspricht somit demjenigen nach Fig. 2b, wobei der rampenförmige Verlauf durch einen amplitudendiskreten, also treppenförmigen Verlauf angenähert wird. Entsprechend wird durch die erste Abtast- und Halteschaltung 12,gesteuert durch das erste Schaltsignal, die Zählerstellung des Zählers 50 abgetastet und als erstes Phasensignal am Ausgang 18 abgegeben.

Das über den Synchronisiersignalanschluß 14 zugeführte, aus einer Folge digitaler Werte bestehende Synchronisiersignal wird in dem Ausführungsbeispiel nach Fig. 3 dem Eingang 13 des Flankendetektors 11 und dem Synchronisiersignaleingang 25 der zweiten Abtast- und Halteschaltung 21 über eine Nullpunkteinstellanordnung 54 zugeleitet, die durch eine gestrichelte Linie angedeutet ist und die einen Subtrahierer 55 und einen Nullpunktgeber 56 umfaßt. Der Nullpunktgeber 56 liefert an einem Ausgang 57 einen im wesentlichen konstanten Wert, der im Subtrahierer 55 vom Synchronisiersignal subtrahiert wird, das dadurch auf einen konstanten Nullpunkt eingestellt wird. Beispielsweise kann der Nullpunktgeber 56 an seinem Ausgang 57 einen dem Mittelwert M in Fig. 2c entsprechenden Wert abgeben, wodurch dann die Mitte zwischen dem Grundwert G und dem Scheitel A der Impulse I im Synchronisiersignal stets den Wert Null annehmen.

Um auch Schwankungen des Mittelwerts M ausgleichen zu können, enthält der Nullpunktgeber 56 in der Schaltungsanordnung nach Fig. 3 eine Einrichtung zum Bestimmen des einzustellenden Nullpunkts, der über einen Eingang 58 des Nullpunktgebers 56 das Synchronisiersignal zugeführt wird und die beispielsweise den Mittelwert M aus dem vom Synchronisiersignal abgetasteten Grundwert G und dem Scheitel A der Impulse I bestimmt. Zum Steuern dieser Einrichtung wird dem Nullpunktgeber 56 weiterhin über einen Takteingang 68 das Taktsignal zugeleitet. Insbesondere kann dann der Flankendetektor 11 als Nulldurchgangsdetektor ausgebildet sein, und für den Wert des zweiten Phasensignals und des daraus abgeleiteten resultierenden Phasensignals ist ein eindeutiger Nullpunkt festgelegt.

Bei dem Ausführungsbeispiel nach Fig. 3 wird das digitale resultierende Phasensignal vom Ausgang 30 der Umschaltvorrichtung 29 über ein Schleifenfilter 59 einen Digital-Analog-Umsetzer 60 zugeführt und das erhaltene analoge Signal wird dem Steuereingang 35 des Oszillators 1 zugeführt, da an diesem zum Steuern der Frequenz des Taktsignals ein analoges Signal anliegen muß. Das Schleifenfilter 59 ist beispielsweise als Proportional-Integral-Glied in an sich bekannter Weise ausgebildet zum Umsetzen des resultierenden Phasensignals vom Ausgang 30 der Umschaltvorrichtung 29 in eine dem Oszillator 1 angepaßte Form. Beispielsweise können durch das Schleifenfilter 59 hochfrequente Signalanteile im resultierenden Phasensignal unterdrückt und so das Verhalten der Schaltungsanordnung beim Ausregeln von Phasenabweichungen beeinflußt werden. Zum Steuern digitaler Filteranordnungen im Schleifenfilter 59, beispielsweise zum Fortschalten darin enthaltener Speicher, wird weiterhin über einen Takteingang 69 das Taktsignal zugeleitet.

Zwischen dem Schleifenfilter 59 und dem Digital-Analog-Umsetzer 60 wird das digitale resultierende Phasensignal außerdem einer Anzapfung 61 zugeleitet, von der es als eine unmittelbare Information über die Frequenz des Taktsignals enthaltendes Signal abgegriffen werden kann. Ein derartiges Signal kann beispielsweise in anderen, nicht dargestellten Stufen zur Signalverarbeitung, mit denen die Schaltungsanordnung nach Fig. 3 beispielsweise in einem Fernsehsignalverarbeitungssystem zusammengefügt werden kann, verwendet werden. Insbesondere kann dies in einem System zur Demodulation digitaler Farbfernsehsignale mit einem mit der Frequenz der Zeilen im Fernsehsignal synchronen Taktsignal bedeutend sein zum Ausgleich von Schwankungen dieses Taktsignals. Wenn nämlich als Synchronisiersignal ein im Fernsehsignal enthaltenes Zeilensynchronsignal verwendet wird, kann das Taktsignal über den Ausgangsanschluß 38 abgegeben werden, während das über die Anzapfung 61 abgegebene digitale Phasensignal eine Information über Schwankungen in der Frequenz und/oder Phase des Taktsignals liefert.

Für eine derartige Anwendung der erfindungsgemäßen Schaltungsanordnung ist es darüber hinaus vorteilhaft, daß die Frequenz des Taktsignals über einen großen Bereich einstellbar ist, da insbesondere im Zusammenwirken mit Bild-aufzeichnungsgeräten das als Synchronisiersignal herange-zogene Zeilensynchronsignal in seiner Frequenz in einem großen Bereich schwanken kann.

Darüber hinaus ist es bei Verwendung der Schaltungsanordnung nach Fig. 3 in einem Fernsehsignalverarbeitungssystem zweckmäßig, daß gesamte Fernsehsignalgemisch, das außer dem Synchronisiersignal auch Bildsignale enthält, mit dem Analog-Digital-Umsetzer 41 in ein digitales Signal umzusetzen. Aus diesem kann dann in einem Eingangssignalfilter 46 das digitale Synchronisiersignal ausgefiltert und dem Synchronisiersignalanschluß 14 zugeführt werden, während die übrigen Signalanteile über einen Fernsehsignalausgang 47 vom Eingangssignalfilter 46 zur weiteren Verarbeitung weitergeleitet werden.

Die Schaltungsanordnung nach Fig. 3 weist ferner einen Frequenzteilerausgangsanschluß 62 auf, über den aus dem frequenzgeteilten Signal mit dem Taktsignal phasenstarr verkoppelte Signale abgegeben werden können, die beispielsweise beim Einsatz der beschriebenen Schaltungsanordnung in einem Fernsehsignalverarbeitungssystem als Horizontalsynchronimpulse verwendbar sind.

Die Steigung des Vergleichssignals nach Fig. 2b über dem Phasenwinkel hat in der Regel einen anderen, wesentlich niedrigeren Wert als die Steigung der Flanke F im Synchronisiersignal, beispielsweise nach Fig. 2c. Um eine Unstetigkeit im Regelverhalten der Schaltungsanordnung nach Fig. 3 beim Umschalten der Umschaltvorrichtung 29 zu vermeiden, werden die Steilheiten des ersten und des zweiten Phasensignals, d.h. die Steigungen des rampenförmigen Vergleichssignals einerseits und der Flanke F im Synchronisiersignal andererseits über der Phase aneinander angeglichen. Dazu ist die Schaltungsanordnung nach Fig. 3 mit einer Steilheitsanpaßschaltung 63 versehen, durch die das erste Phasensignal vom Ausgang 18 der ersten Abtast- und Halteschaltung 12 in einem Multiplizierer 64 mit einem Steilheitsanpaßfaktor multipliziert wird, bevor es dem ersten Eingang 27 der Umschaltvorrichtung 29 zugeführt wird. Der Steilheitsanpaßfaktor wird dem Multiplizierer 64 aus einer Speicheranordnung 65 zugeführt. Der Steilheitsanpaßfaktor kann in der Speicheranordnung 65 als Festwert oder auch als einstellbarer Wert gespeichert sein.

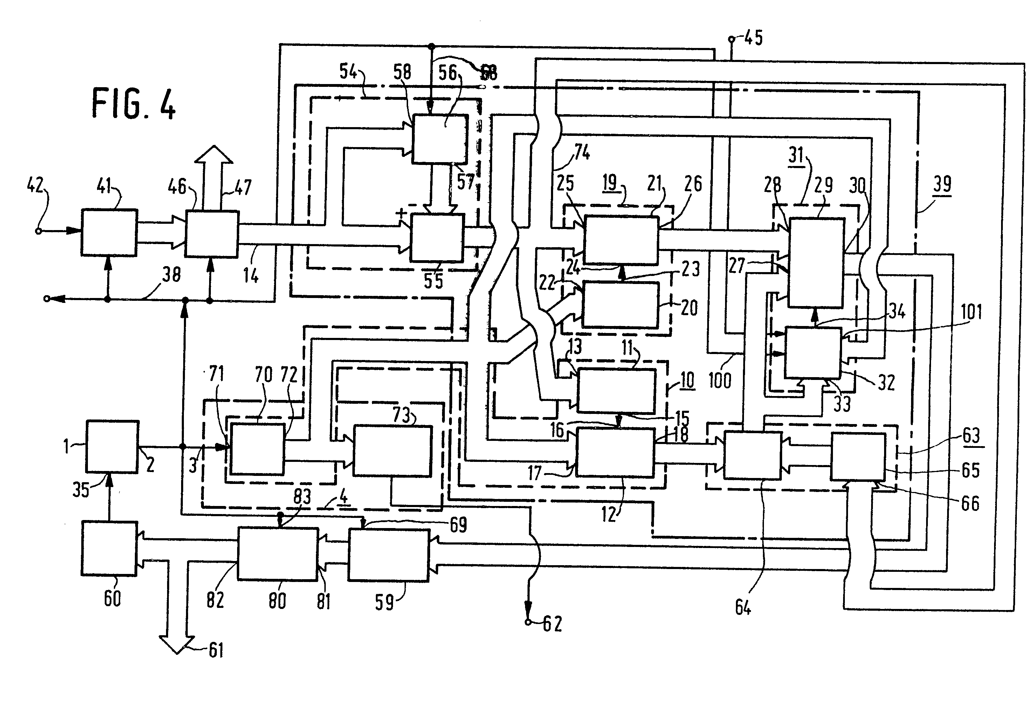

Fig. 4 zeigt eine Abwandlung der Schaltungsanordnung nach Fig. 3, wobei mit dieser übereinstimmende Teile der Schaltungsanordnung mit identischen Bezugszeichen versehen sind.

Als erste Abwandlung gegenüber Fig. 3 sind in der Schaltungsanordnung nach Fig. 4 der Frequenzteiler 4 und der Zähler 50 durch einen abgewandelten Zähler 70 und eine Decodierstufe 73 ersetzt worden. Der abgewandelte Zähler 70 weist im Gegensatz zum Zähler 50 nur einen Zähleingang 71 auf, dem die Schwingung vom Ausgang 2 des Oszillators 1 zugeleitet wird. Der Zähler 70 ist mit einer Rückstelleinrichtung versehen, durch die er nach einer bestimmten Anzahl von Zählschritten in eine Anfangsstellung zurückgesetzt wird. Diese Anzahl von Zählschritten entspricht der ganzen Zahl, durch die die Frequenz des Taktsignals im Frequenzteiler 4 geteilt wird.Am Ausgang 72 des Zählers 70 wird dann eine Folge von Zählerstellungen als digitale Signale abgegeben, die ein digitales, rampenförmiges Vergleichssignal entsprechend Fig. 2b bilden, das unmittelbar dem Eingang 22 des Bezugswertdurchgangsdetektors 20 sowie dem Vergleichssignaleingang 17 der ersten Abtast- und Halteschaltung 12 zugeleitet wird. Das Vergleichssignal wird außerdem der Decodierstufe 73 zugeführt, die bestimmte Zählerstellungen decodiert und ein frequenzgeteiltes Signal an dem Frequenzteilerausgangsanschluß 62 abgibt. Da bei der Schaltungsanordnung nach Fig. 4 das frequenzgeteilte Signal nicht mehr im Phasendetektor 39 benötigt wird, kann es durch die Decodierstufe 73 unmittelbar einer weiteren Verarbeitung, beispielsweise als Horizontalsynchronimpulse, angepaßt werden. In der Fig. 4 ist durch die gestrichelt gezeichneten Umrandungen 4 und 10 angedeutet, daß der Zähler 70 dem Frequenzteiler 4 und der ersten Vergleichsanordnung 10 gemeinsam ist.

In der Schaltungsanordnung nach Fig. 4 ist weiterhin die Speicheranordnung 65 der Steilheitsanpaßschaltung 63 mit einem Eingang 66 versehen, dem mittels einer Leitungsverbindung 74 vom Ausgang des Subtrahierers 55 der Nullpunkteinstellanordnung 54 das Synchronisiersignal zugeleitet wird. Die Speicheranordnung 65 ist dann mit einer Detektieranordnung ausgestattet, durch die die Amplitude des Synchronisiersignals ermittelt und daraus der Steilheitsanpaßfaktor bestimmt wird. Gegebenenfalls kann der Detektieranordnung in der Speicheranordnung 65 als Referenz dazu über einen weiteren Eingang das Vergleichssignal zugeführt werden. In noch vorteilhafterer Weise kann der Speicheranordnung 65 jedoch ein die Amplitude des Synchronisiersignals darstellendes Signal aus dem Nullpunktgeber 56 am Eingang 66 zugeführt werden, wenn der Nullpunktgeber zum Festlegen des Nullpunkts des Synchronisiersignals dessen Amplitude ermittelt.

In den Signalweg des resultierenden Phasensignals ist weiterhin zwischen dem Schleifenfilter 59 und dem Digital-Analog-Umsetzer 60 bzw. der Anzapfung 61 ein Interpolationsfilter 80 eingefügt. Ihm wird das resultierende Phasensignal vom Schleifenfilter 59 an einem Phasensignaleingang 81 zugeführt, und das im Interpolationsfilter 80 umgewandelte Phasensignal wird von einem Phasensignalausgang 82 dem Digital-Analog-Umsetzer 60 zugeführt. An einem Takteingang 83 wird dem Interpolationsfilter 80 das Taktsignal vom Oszillator 1 zugeleitet.

Das Interpolationsfilter 80 wandelt Sprünge im resultierenden Phasensignal, wie sie beispielsweise durch sprungartige Phasenverschiebungen der Impulse im Synchronisiersignal auftreten können, in rampenförmige Übergänge um. Dies kann beispielsweise in der Art erfolgen, daß bei einer sprunghaften Veränderung des resultierenden Phasensignals am Phasensignaleingang 81 der Wert des umgewandelten Phasensignals am Phasensignalausgang 82 gemäß einer rampenförmigen Veränderung mit einer festgelegten, gleichbleibenden Steigung solange verändert wird, bis der Wert am Phasensignalausgang dem Wert am Phasensignaleingang angeglichen ist. Die Höhe des Sprunges im resultierenden Phasensignal wird dann unmittelbar in die Länge der erzeugten Rampe umgesetzt. Dadurch ist dann die Geschwindigkeit einer vom resultierenden Phasensignal hervorgerufenen Frequenzänderung des Taktsignals ebenfalls begrenzt.

Einerseits wird so das über die Anzapfung 61 abgegebene, digitale Phasensignal von unkontrollierten Sprüngen befreit. Andererseits kann das Einschwingverhalten des Oszillators 1 bei Änderungen im resultierenden Phasensignal verbessert werden insbesondere dann, wenn die Dauer des Anstiegs der Rampe im Phasensignal groß ist gegenüber einer das Einschwingverhalten des Oszillators 1 bestimmenden Zeitkonstanten. Das Ausregeln von Phasensprüngen im Synchronisiersignal durch die Schaltungsanordnung wird bei Verwendung eines Interpolationsfilters 80 in der Regel geringfügig verzögert. Da außerdem das Interpolationsfilter zusätzlich zu den synchronisiersignalfrequenten Werten des resultierenden Phasensignals weitere, interpolierte Werte liefert, muß der Digital-Analog-Umsetzer 60 eine entsprechend erhöhte Umsetzrate aufweisen.

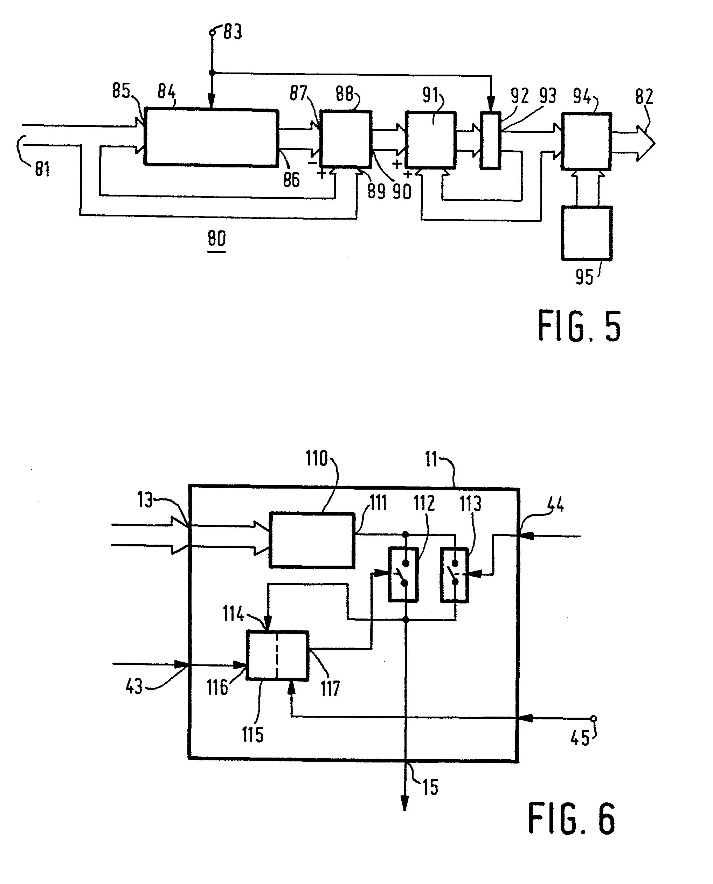

In einem anderen Beispiel ist das Interpolationsfilter 80 derart ausgebildet, daß es die Steigung in der Rampe des umgewandelten Phasensignals am Phasensignalausgang 82 der Höhe eines Sprunges im resultierenden Phasensignal am Phasensignaleingang 81 anpaßt. Ein Beispiel für eine derartige Schaltungsanordnung ist in der Fig. 5 dargestellt. Es umfaßt ein mehrstelliges Schieberegister 84, dem an einem Eingang 85 vom Phasensignaleingang 81 die Werte des Phasensignals zugeführt werden und das sie in einem durch das am Takteingang 83 zugeführte Taktsignal bestimmten Takt abspeichert. Dabei wird jeder der mit der Wiederholfrequenz der Impulse im Synchronisiersignal zugeführten Werte des resultierenden Phasensignals entsprechend einer durch den Takt bestimmten Anzahl von Interpolationsstellen zwischen zwei Werten des resultierenden Phasensignals mehrfach im Schieberegister gespeichert. Länge des Schieberegisters und Takt sind derart aufeinander abgestimmt, daß die am Eingang 85 zugeführten Werte des resultierenden Phasensignals jeweils nach einer Periode des Synchronisiersignals an einem Ausgang 86 des Schieberegisters 84 auftreten und von dort einem negativen Eingang 87 eines Subtrahierers 88 zugeleitet werden. Einem positiven Eingang 89 des Subtrahierers 88 wird das resultierende Phasensignal vom Phasensignaleingang 81 unverzögert zugeleitet. Der Subtrahierer 88 gibt an einem Ausgang 90 die Differenz zwischen dem augenblicklichen und dem um eine Periode des Synchronisiersignals verzögerten Wert des resultierenden Phasensignals ab. Diese wird in einem aus einem Addierer 91 und einem Register 92 in bekannter Weise gebildeten Akkumulator aufakkumuliert. Am Ausgang 93 des Akkumulators wird dann die Summe der zum jeweiligen Zeitpunkt im Schieberegister gespeicherten Werte des resultierenden Phasensignals abgegeben und einem Dividierer 94 zugeleitet, in dem sie durch die Anzahl der im Schieberegister 84 gespeicherten Wert dividiert wird, so daß am Ausgang des Dividierers 94, der mit dem Phasensignalausgang 82 des Interpolationsfilters 80 verbunden ist, der Mittelwert der im Schieberegister 84 gespeicherten Werte und damit ein gewichteter Mittelwert zweier aufeinander folgender Werte des resultierenden Phasensignals abgegeben wird. Die Folge der gewichteten Mittelwerte bildet dann gerade den rampenförmigen Übergang zwischen zwei aufeinander folgenden Werten des resultierenden Phasensignals. Dem Dividierer 94 wird ein der Stellenzahl des Schieberegisters 84 entsprechender Teiler von einem Speicher 95 zugeführt. Gegebenenfalls können die Stellenzahl des Schieberegisters 84 und der Teiler im Speicher 95 veränderbar, d.h. umschaltbar sein.

Bei der Schaltungsanordnung nach Fig. 4 ist weiterhin im Grenzwertdetektor 32 eine Einrichtung zur Störimpulsunterdrückung angeordnet. Dieser werden über einen Takteingang 100 das Taktsignal und über einen Vergleichssignaleingang 101 die Zählerstellungen des Zählers 70 zugeführt. Mit diesen Zählerstellungen wird im Grenzwertdetektor 32 ein Zeitfenster festgelegt, außerhalb dessen ein über den Eingang 33 zugeführtes erstes Phasensignal unberücksichtigt bleibt. Wie auch zu Fig. 1 beschrieben, kann das Zeitfenster abhängig von der Stellung der Umschaltvorrichtung 29, d.h. abhängig vom Auswahlsignal am Ausgang 34 des Grenzwertdetektors 32, für den Betriebszustand der Grob- bzw. Feinphasendetektion ein- oder ausgeschaltet werden, oder es kann die Breite des Zeitfensters umschaltbar sein. Das Ein-, Aus- bzw. Umschalten kann auch über eine Stellsignalleitung 45 durch von außen zugeführte Signale vorgenommen werden.

Fig. 6 zeigt als Beispiel einer Einrichtung zur Unterdrückung von Störimpulsen eine entsprechende Ausbildung des Flankendetektors 11, wie er beispielsweise in den Schaltungsanordnungen nach Fig. 1 oder 3 Anwendung findet. Das dem Flankendetektor 11 über den Eingang 13 zugeführte Synchronisiersignal wird einem Schaltsignalgenerator 110 zugeführt, der beim Auftreten einer Flanke F an seinem Ausgang 111 als erstes Schaltsignal beispielsweise einen Impuls abgibt, der über eine parallele Anordnung zweier Torschaltungen 112, 113 dem Ausgang 15 des Flankendetektors 11 sowie einem Starteingang 114 eines Kontrollzählers 115 zugeführt wird. Dem Kontrollzähler wird ferner an einem Zähleingang 116 das Taktsignal vom Taktsignaleingang 43 zugeleitet. Der Kontrollzähler 115 wird durch den Impuls am Starteingang 114 gestartet und zählt die Perioden des Taktsignals. Ein im Kontrollzähler 115 enthaltener Dekoder dekodiert bestimmte Zählerstellungen und gibt an einem Ausgang 117 ein Austastsignal ab, durch das die erste Torschaltung 112 nur in einem Zeitintervall durchlässig geschaltet wird, das einen Zeitpunkt enthält, der von der letzten Flanke F im Synchronisiersignal eine Periode desselben entfernt ist. Außerhalb dieses Zeitintervalls ist die erste Torschaltung 112 gesperrt. Dadurch werden außerhalb des Zeitintervalls auftretende, durch Störungen hervorgerufene Flanken im Synchronisiersignal unterdrückt, d.h. es werden keine Impulse zum Ausgang 15 durchgegeben.

Erst der durch die nächste Flanke F im Synchronisiersignal erzeugte, phasenrichtige Impuls vom Ausgang 111 des Schaltsignalgenerators 110 wird an den Ausgang 15 des Flankendetektors 11 weitergeleitet und startet außerdem den Kontrollzähler 115 über den Starteingang 114 neu derart, das dieser die Perioden des Taktsignals von neuem zu zählen beginnt.

Der Kontrollzähler 115 kann derart ausgebildet sein, daß er beim Ausbleiben einer phasenrichtigen Flanke F am Ende des Zeitintervalls in einer bestimmten Zählstellung stehen bleibt und in dieser die erste Torschaltung 112 entweder im gesperrten oder im durchlässigen Zustand hält. Er kann jedoch am Ende des Zeitintervalls auch selbsttätig von neuem zu zählen beginnen. Damit läßt sich beispielsweise erreichen, daß beim Ausbleiben einer phasenrichtigen Flanke F in dem genannten Zeitintervall am Ausgang 18 der ersten Abtast- und Halteschaltung 12 der bisherige Wert des ersten Phasensignals erhalten bleibt und damit beispielsweise verhindert wird, daß die gesamte Schaltungsanordnung bereits beim Ausbleiben einer einzigen Flanke im Synchronisiersignal aus dem synchronisierten Zustand gerät.

Hält der Kontrollzähler 115 nach Erreichen einer bestimmten Zählstellung selbsttätig an und bleibt die erste Torschaltung 112 in diesem Zustand durchlässig, befindet sich der Flankendetektor 11 in einer Wartestellung, in der er auf die nächste Flanke F im Synchronisiersignal wartet, wenn die Schaltungsanordnung aus dem synchronisierten Zustand geraten ist.

Die zweite Torschaltung 113 wird über den Auswahlsignaleingang 44 direkt vom Auswahlsignal am Ausgang 34 des Grenzwertdetektors 32 gesteuert. Damit kann im Betriebszustand der Grobphasendetektion die beschriebene Einrichtung zur Unterdrückung von Störimpulsen überbrückt, d.h. unwirksam geschaltet werden, bis die gesamte Schaltungsanordnung wieder im synchronisierten Zustand ist.

In einem Ausführungsbeispiel der erfindungsgemäßen Schaltungsanordnung wird als Synchronisiersignal ein impulsförmiges Zeilensynchronsignal mit der Frequenz von 15,625 kHz (PAL-Norm) zugeführt. Das vom Oszillator 1 abgegebene Taktsignal weist eine Frequenz von 13,5 MHz auf. Der Frequenzteiler 4 teilt diese Schwingung in ihrer Frequenz um den Faktor 864, so daß das frequenzgeteilte Signal die Frequenz des Zeilensynchronsignals aufweist. Auch bei der SECAM-Norm wird die Frequenz des Taktsignalsvorzugsweise auf 13,5 MHz festgelegt und im Frequenzteilerum die ganze Zahl 864 geteilt. Bei anderen Normen, beispielsweise PAL N, PAL M, NTSC und anderen, teilt dagegen der Frequenzteiler 4 die Frequenz des Taktsignalsvorzugsweise um 858.

## PATENTANSPRÜCHE

1. Schaltungsanordnung zum Synchronisieren der Phase eines frequenzgeteilten Signals mit einer Flanke endlicher Steigung eines im wesentlichen periodischen Synchronisiersignals mit

- einem ein Taktsignal abgebenden Oszillator mit steuerbarer Frequenz,

- einem Frequenzteiler, der durch Teilen der Frequenz des Taktsignals durch eine ganze Zahl das frequenzgeteilte Signal erzeugt,

- und mit einem Phasendetektor, der umfaßt:

- eine erste Vergleichsanordnung zum Bestimmen des Phasenunterschieds zwischen einem Bezugszeitpunkt im frequenzgeteilten Signal und der Flanke des Synchronisiersignals und zur Abgabe eines ersten Phasensignals, das ein Maß für diesen Phasenunterschied ist,

- eine zweite Vergleichsanordnung zum Abtasten des Wertes des Synchronisiersignals im Bezugszeitpunkt und zur Abgabe eines aus diesem Wert gebildeten zweiten Phasensignals,

- sowie eine Auswahlschaltung, die ein resultierendes Phasensignal, das dem Oszillator zum Steuern der Frequenz des Taktsignals zugeführt wird, aus dem ersten Phasensignal ableitet, wenn dieses einen Grenzwert überschreitet, und die sonst das resultierende Phasensignal aus dem zweiten Phasensignal ableitet, dadurch gekennzeichnet, daß das Synchronisiersignal dem Phasendetektor in Form einer Folge amplitudendiskreter Werte zugeführt wird, die durch Abtasten des Synchronisiersignals mit dem Taktsignal gebildet wird, wobei für die Flanke im Synchronisiersignal eine ausreichende Anzahl Amplitudenstufen vorgesehen ist.

2. Schaltungsanordnung nach Anspruch 1, dadurch gekennzeichnet, daß das resultierende Phasensignal nach Überschreiten des Grenzwertes durch das erste Phasensignal erst dann aus diesem abgeleitet wird, wenn es den Grenzwert innerhalb eines bestimmten Zeitintervalls nach Auftreten der jeweils letzten Flanke im Synchronisiersignal überschreitet.

3. Schaltungsanordnung nach Anspruch 1 oder 2, dadurch gekennzeichnet, daß die erste Vergleichsanordnung einen Signalgenerator zum Abgeben eines im wesentlichen rampenförmigen Vergleichssignals umfaßt, sowie einen Flankendetektor und eine erste Abtast- und Halteschaltung zum Speichern des augenblicklichen Wertes des rampenförmigen Vergleichssignals und zum Abgeben dieses Wertes als erstes Phasensignal, wenn der Flankendetektor die Flanke im Synchronisiersignal detektiert.

4. Schaltungsanordnung nach Anspruch 3, dadurch gekennzeichnet, daß der Bezugszeitpunkt durch einen Durchgang des Vergleichssignals durch einen Bezugswert bestimmt ist und daß die zweite Vergleichsanordnung einen Bezugswertdurchgangsdetektor und eine zweite Abtast- und Halteschaltung zum Speichern des augenblicklichen Wertes des Synchronisiersignals und zum Abgeben dieses Wertes als zweites Phasensignal umfaßt, wenn der Bezugswertdurchgangsdetektor einen Durchgang des Vergleichssignals durch den Bezugswert detektiert.

5. Schaltungsanordnung nach Anspruch 4, dadurch gekennzeichnet, daß der zweiten Vergleichsanordnung an einem Synchronisiersignaleingang, über den ihr das Synchronisiersignal zugeführt wird, eine Nullpunkteinstellanordnung vorgeschaltet ist, über die das Synchronisiersignal der zweiten Vergleichsanordnung zugeleitet wird.

6.     Schaltungsanordnung nach Anspruch 3,
dadurch gekennzeichnet, daß zwischen die Auswahlschaltung
und die erste Vergleichsanordnung eine Steilheitsanpaßschaltung zum aneinander Angleichen der Steigungen des
rampenförmigen Vergleichssignals und der Flanke des
Synchronisiersignals geschaltet ist, über die das erste
Phasensignal der Auswahlschaltung zugeleitet wird.

7.     Schaltungsanordnung nach Anspruch 3,
dadurch gekennzeichnet, daß der Frequenzteiler und der
Signalgenerator durch einen gemeinsamen, vom Taktsignal
fortgeschalteten Zähler gebildet sind.

8.     Schaltungsanordnung nach einem der vorhergehenden
Ansprüche zur Verwendung in einer Anordnung zum Gewinnen
einer Folge amplitudendiskreter Fernsehsignalwerte aus
einem analogen Fernsehsignal, dadurch gekennzeichnet, daß
das Synchronisiersignal ein im Fernsehsignal enthaltenes
Zeilensynchronsignal ist, das Taktsignal zum Gewinnen der
amplitudendiskreten Fernsehsignalwerte dient und der
Frequenzteiler aus dem frequenzgeteilten Signal Horizontalsynchronimpulse ableitet.

9.     Schaltungsanordnung nach Anspruch 8,
dadurch gekennzeichnet, daß das resultierende Phasensignal
über einen Digital-Analog-Umsetzer dem Oszillator zugeleitet wird.

10.     Schaltungsanordnung nach einem der vorhergehenden
Ansprüche, dadurch gekennzeichnet, daß das resultierende
Phasensignal dem Oszillator über ein Interpolationsfilter
zugeleitet wird.

35

FIG. 1

1-V-PHD 84-129

FIG. 2

0174049

FIG. 3

FIG. 4

0174049

FIG. 5

FIG. 6